# EUROPÄISCHE PATENTSCHRIFT

(11) **EP 0 992 070 B1**
(45) Veröffentlichungstag und Bekanntmachung des Hinweises auf die Patenterteilung: **08.01.2003**
(21) Anmeldenummer: 98929357.6
(22) Anmeldetag: 22.05.1998
(51) Int. Cl.: H01L 29/872, H01L 29/861

(54) **LEISTUNGSHALBLEITER-BAUELEMENT UND VERFAHREN ZU DESSEN HERSTELLUNG**
SEMICONDUCTOR COMPONENT AND METHOD FOR PRODUCING THE SAME
COMPOSANT A SEMI-CONDUCTEUR DE PUISSANCE ET PROCEDE PERMETTANT DE LE PRODUIRE

(30) Priorität: 03.06.1997 DE 19723176
(43) Veröffentlichungstag der Anmeldung: 12.04.2000
(73) Patentinhaber: DaimlerChrysler AG, 70567 Stuttgart (DE)
(72) Erfinder: KAMINSKI, Nando, CH-5034 Suhr (DE); HELD, Raban, D-63667 Mömbris (DE)
(86) Internationale Anmeldenummer: EP9803010
(87) Internationale Veröffentlichungsnummer: WO98056043

(56) Entgegenhaltungen:
- DE-A- 4 210 402
- DE-A- 19 633 183
- DE-U- 29 504 629
- US-A- 5 262 669
- ITOH A ET AL: "EXCELLENT REVERSE BLOCKING CHARACTERISTICS OF HIGH-VOLTAGE 4H-SIC SCHOTTKY RECTIFIERS WITH BORON-IMPLANTED EDGE TERMINATION" IEEE ELECTRON DEVICE LETTERS, Bd. 17, Nr. 3, 1. März 1996, Seiten 139-141, XP000584756
- MOHAMMAD S N ET AL: "NEAR-IDEAL PLATINUM-GAN SCHOTTKY DIODES" ELECTRONICS LETTERS, Bd. 32, Nr. 6, 14. März 1996, Seite 598/599 XP000593659
- RAO M V ET AL: "AL AND N ION IMPLANTATIONS IN 6H-SIC" INSTITUTE OF PHYSICS CONFERENCE SERIES, 18. September 1995, Seiten 521-524, XP002047800
- B.M. Wilamoski, "Schottky Diodes with High Breakdown Voltages", Solid-State Electronics, vol. 26(5), S. 491-493

## Beschreibung

Die Erfindung betrifft ein Halbleiterbauelement mit alternierend angeordneten Schottky- und pn-Übergängen und zwischen den Schottky- und pn-Übergängen angeordneten niedrigdotierten Driftzonen eines Halbleitermaterials sowie ein Verfahren zur Herstellung eines Bauelements.

Als Bauelemente, die für kleine Betriebsspannungen vorgesehen sind, finden neben pn-Dioden auch Schottky-Dioden Verwendung. Schottky-Dioden zeichnen sich durch geringere Durchlaßspannungen und geringe Schaltverluste aus. Um die am Rand des Schottky-Übergangs auftretenden Feldspitzen zu reduzieren, werden häufig sogen. Schutzringe am Rand des Bauelements vorgesehen. Diese Schutzringe reduzieren die am Rand des Schottky-Übergangs auftretenden Feldspitzen und tragen vorteilhaft zur Erhöhung der Durchbruchsspannung des Bauelements bei.

Allerdings steigen mit erhöhter Durchbruchspannung der Diode sowohl die Serienwiderstände im Bauelement als auch die Sperrleckströme, insbesondere bei erhöhten Temperaturen. Dadurch wird der erweiterte Einsatz der an sich technologisch einfachen Schottky-Dioden erschwert.

Ein besonderes Problem stellt die starke Spannungsabhängigkeit des Sperrleckstromes aufgrund der spannungsinduzierten Deformation der energetischen Barriere des Schottky-Übergangs dar. Die Schottky-Barriere wird durch eine angelegte Sperrspannung und das damit verbundene elektrische Feld an der Barriere verkleinert, so daß der Sperrleckstrom stark mit der Sperrspannung ansteigt und bereits vor dem eigentlichen Durchbruch sehr hohe Werte annehmen kann. Zusätzlich zeigen die Sperrströme aufgrund des zugrundeliegenden thermischen Emissionsmechanismus einen exponentiellen Anstieg mit der Temperatur, woraus sich ein unvorteilhaftes Sperrverhalten ergibt.

Schottky-Dioden aus unterschiedlichen Halbleitermaterialien sind bekannt. In der EP 380 340 A2 ist eine Schottky-Diode aus SiC beschrieben, in dem Artikel von L. Wang et al., "High Barrier Height GaN Schottky-Diodes: Pt/GaN and Pd/GaN" in Appl. Phys. Lett. 68(9), 26, Feb. 1996 1267-1269 sind Schottky-Dioden aus GaN offenbart, während Schottky-Dioden aus Diamant aus der DE 42 10 402 A1 bekannt sind.

Aus der DE 2 95 04 629 U1 und aus der Veröffentlichung IEEE Electron Device Letters, Vol. 17, No 3, March 1996: "Excellent Reverse Blocking Characteristics of High-Voltage 4H-SiC Schottky Rectifiers with Boron-implanted Edge Termination" von Akira Itoh, Tsunenobu and Hiroyuki Matsunami sind jeweils SiC-Dioden mit Guard Ring bekannt. In der DE 2 95 04 629 U1 wird eine Schottky Elektrode aus Titan und Aluminium vorgeschlagen und in der IEEE Veröffentlichung wird eine Schottky Elektrode aus Titan untersucht.

In der Literatur sind verschiedene Ansätze beschrieben, das Sperrverhalten zu verbessern, z.B. in B.M. Wilamowski, "Schottky Diodes with High Breakdown Voltages", Solid-State Electronics, vol. 26(5), S. 491-493, 1983 und B.J. Baliga, "The Pinch Rectifier: A Low-Forward-Drop High-Speed Power Diode", IEEE Electron Device Letters, EDL-5(6), 1984. Dort wird davon ausgegangen, daß die elektrische Feldstärke am Schottky-Übergang durch eine Abschirmung verringert wird. Das dort beschriebene Bauelement stellt eine sogen. "Merged-pn/Schottky (MPS) Rectifier" dar, bei der innerhalb der Schutzringanordnung alternierend Schottky-Kontakte und hochdotierte pn-Übergänge mit dazwischenliegende n-Driftzonen eines Halbleitermaterials angeordnet sind. Zwar ist das Sperrverhalten dieser Bauelemente verbessert, es treten jedoch verschiedene Nachteile auf.

Neben dem Verlust von aktiver Fläche für die Schottky-Übergänge ist insbesondere die Injektion von Minoritätsladungsträgern aus dem hochdotierten Halbleitergebiet im Vorwärtsbetrieb der pn-Kontakte nachteilig. Bei einer Vorwärtspolung des MPS-Bauelements fließt der Strom zunächst nur über die Schottky-Bereiche. Bei weiter steigender Vorwärtsspannung geraten dann auch die pn-Übergänge in Durchlaß, wobei Minoritätsladungsträger in das Driftgebiet injiziert werden. Anders als bei Bauelementen, welche nur Schutzringanordnungen aufweisen, ist diese Minoritätsladungsträger-Injektion nicht mehr zu vernachlässigen, da die Ladungsträgerinjektion wie bei reinen pn-Dioden sogar zur Bildung eines Elektron-Loch-Plasmas führen kann. Einerseits sind dann zwar die Durchlaßeigenschaften leicht verbessert, andererseits steigen die Schaltverluste jedoch stark an.

In der Literatur sind eine Reihe von Maßnahmen beschrieben, mit denen das Schalt- und Sperrverhalten der MPS-Bauelemente verbessert werden soll. In der US 5,262,669 A ist beschrieben, bei MSP-Bauelementen die pn-Übergänge in geätzten Gräben anzuordnen sowie die Geometrie der pn-Übergänge der Barrierenhöhe des Schottky-Übergangs bzw. der sich am Schottky-Übergang ausbildenden Raumladungszone anzupassen. Die verwendeten Technologien und Anordnungen sind allerdings technologisch sehr aufwendig. Aus diesen Gründen haben MPS-Bauelemente trotz der im Prinzip einfachen Herstelltechnologie und der vorteilhaften Eigenschaften unipolarer Dioden keinerlei praktische Bedeutung.

Der Erfindung liegt die Aufgabe zugrunde, ein MPS-Bauelement anzugeben, bei dem Schaltverluste verbessert sind, ohne aufwendige Technologieschritte zusätzlich anwenden zu müssen.

Die Aufgabe wird durch die Merkmale der unabhängigen Ansprüche gelöst. Weiterführende und vorteilhafte Ausgestaltungen sind den Unteransprüchen und der Beschreibung zu entnehmen.

Vorteilhaft ist, daß die einfache Technologie der MPS-Bauelemente eingesetzt werden kann und sowohl die Sperreigenschaften als auch die Abschaltverluste verbessert sind.

Besonders vorteilhaft ist es, Halbleiter mit großer Energielücke, insbesondere sogen. 'wideband-gap' Halbleiter, zu verwenden. Es ist günstig, das Material für den Schottkykontakt so zu wählen, daß eine Mindestbarrierenhöhe nicht unterschritten wird. Die Sperreigenschaften sind damit verbessert.

Die Driftzone ist aus Siliziumkarbid gebildet.

Auf einem hochdotierten Substratmaterial aus Siliziumkarbid ist eine Driftzone gleichen Leitfähigkeitstyps mit niedrigerer Dotierung angeordnet. Die Substratmaterial-Dotierung ist größer oder gleich 10¹⁸ cm⁻³ und die Driftzonen-Dotierung von 10¹⁴ cm⁻³ bis 10¹⁷ cm⁻³.

In einer günstigen Ausführung weist das Driftzonengebiet eine Dicke zwischen 2 µm und 50 µm auf.

In einer Ausführung ist der Abstand benachbarter pn-Übergänge zwischen 0,5 µm und 20 µm.

In einer weiteren Ausführung sind pn-Übergänge in Gräben, welche in das Innere des Driftgebiets hineingeätzt wurden, angeordnet.

In einer Ausführung sind Schottky-Übergänge benachbart zu den pn-Übergängen im Driftgebiet angeordnet.

Die hochdotierten Gebiete im Driftgebiet sind durch das komplementär dotierte Halbleitermaterial des Driftgebiets gebildet.

In einer weiteren Ausführung sind die hochdotierten Gebiete im Driftgebiet durch unterschiedliches Halbleitermaterial gebildet.

In einer günstigen Ausführung ist für p-dotiertes Substratmaterial Aluminium und/oder Bor in das Dotiergebiet eingebracht.

In einer günstigen Ausführung ist für n-dotiertes Substratmaterial Stickstoff und/oder Phosphor in das Dotiergebiet eingebracht.

In einer Ausführung sind die Kathode und die Anode auf gegenüberliegenden Oberflächen des Halbleiterbauelements angeordnet.

In einer bevorzugten Ausführung sind die Kathode und die Anode auf derselben Oberfläche des Halbleiterbauelements angeordnet, insbesondere umschließt der eine äußere Kontakt den anderen äußeren Kontakt.

In einer Ausführung kontaktiert ein äußerer Kontakt das Driftgebiet im wesentlichen punktuell.

In einer weiteren Ausführung ist der Kathode ein hochdotiertes Halbleitergebiet vorgelagert, welches denselben Leitfähigkeitstyp aufweist wie das Driftgebiet des Halbleiters.

In einem erfindungsgemäßen Verfahren ist die Herstellung eines erfindungsgemäßen Siliziumkarbid-Bauelements angegeben. In einer bevorzugten Ausführungsart wird eine besonders günstige Temperaturbehandlung durchgeführt. Der Vorteil ist, daß die Oberflächenrauhigkeit des Bauelements bei der Temperaturbehandlung nicht verschlechtert wird.

Im folgenden sind die Merkmale, soweit sie für die Erfindung wesentlich sind, eingehend erläutert und anhand von Figuren näher beschrieben. Es zeigen
- Fig. 1: den Verlauf von Kennlienien von erfindungsgemäßen Bauelementen und von Kennlinien verschiedener bekannter Bauelemente,
- Fig. 2: einen Schnitt durch eine Schottky-Diode mit Schutzring nach dem Stand der Technik,
- Fig. 3: einen Schnitt durch ein MPS-Bauelement
- Fig. 4: die Abschaltkennlinie eines nach dem erfindungsgemäßen Verfahren hergestellten Bauelement im Vergleich zur Kennlinie einer pn-Diode nach dem Stand der Technik,
- Fig. 5: einen Schnitt durch ein nach dem erfindungsgemäßen Verfahren hergestellten MPS-Bauelement,
- Fig. 6: einen Schnitt durch ein nach dem erfindungsgemäßen Verfahren hergestellten MPS-Bauelement.

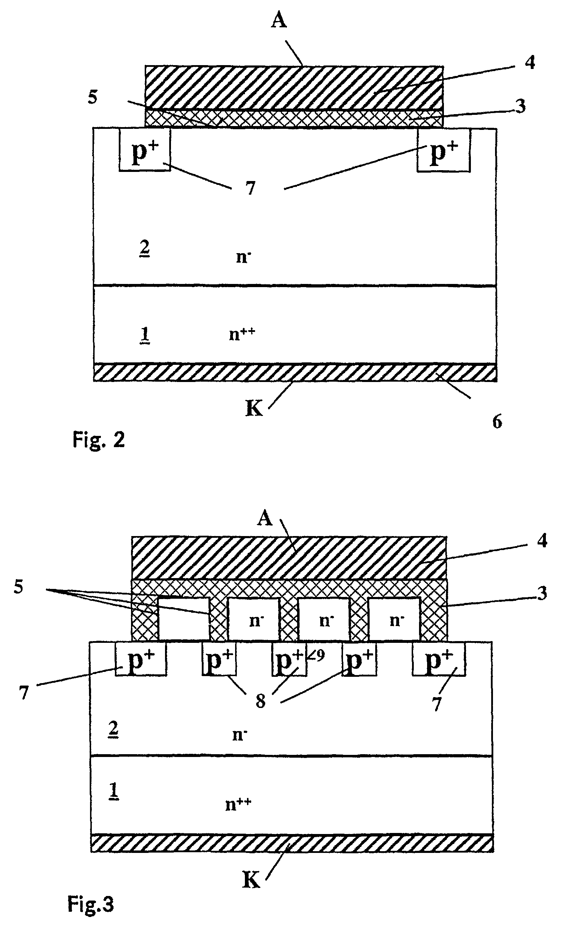

In Fig. 2 ist ein Schnitt durch eine Schottky-Diode mit Schutzring nach dem Stand der Technik dargestellt. In der üblichen Anordnung ist auf einem hochdotierten n⁻ Substrat 1 ein niedrigdotiertes n⁻ Halbleitergebiet 2, insbesondere eine epitaktische Schicht, angeordnet. Auf der Oberfläche der Halbleiterschicht 2 ist ein Schottky-Kontakt angeordnet, der aus einer ersten Metallschicht, dem Schottky-Metall 3 und einem zweiten Kontaktierungs-Metallsystem 4 gebildet ist. Zum Halbleiter hin bildet sich der Schottky-Übergang 5. Der Schottky-Kontakt bildet die Anode A. Auf der der Anode A gegenüberliegenden Seite des Substrates 1 ist ein drittes Kontaktierungs-Metallsystem 6 angeordnet, welches die Kathode K bildet. Unter dem Randbereich der Schottky-Kontakt-Anordnung ist ein hochdotiertes Halbleitergebiet 7 angeordnet mit einem zum Halbleitergebiet 2 komplementären Ladungsträgertyp. Das Halbleitergebiet 2 stellt die Driftzone für Ladungsträger dar. Das Halbleitergebiet 7 bildet den Schutzring (sogen. 'Guard Ring'), der die sonst am Rand des Schottky-Kontaktes auftretenden elektrischen Feldspitzen reduziert und so dessen Durchbruchsspannung erhöht.

Fig. 3 zeigt eine Weiterbildung der Anordnung aus Fig. 2 in Form eines Schnitts durch ein MPS-Bauelement. In der Anordnung werden durch eine Abschirmung unter dem Schottky-Kontakt die Feldspitzen weiter verringert. Die Abschirmung besteht aus einem Gitter von hochdotierten Halbleitergebieten 8, welche wie der Schutzring 7 einen zur Halbleiterschicht 2 komplementären Ladungsträgertyp aufweisen. In der Figur 3 wird die Abschirmanordnung 7 durch p-Gebiete gebildet. Im wesentlichen bildet sich eine Anordnung mit alternierend angeordneten Schottky-Übergängen 5 und pn-Übergängen 9 mit dazwischenliegenden Driftzonen 10 des Halbleitergebiets 2.

Wird an diese Anordnung eine Sperrspannung zwischen Anode A und Kathode K angelegt, so dehnt sich die Raumladungszone mit steigender Spannung nicht nur vom Schottky-Übergang, sondern auch von den Halbleitergebieten der Abschirmanordnung 8 her aus. Bei entsprechender üblicher Dimensionierung werden die Schottky-Bereiche zwischen den p-Gebieten 8 von deren Raumladungszonen abgeschnürt, so daß die elektrische Feldstärke am Schottky-Übergang 5 kaum weiter ansteigt. Die Anordnung entspricht in etwa einer Kaskode aus Schottky-Diode und einem sogen. 'Static induction Transistor'.

Diese Struktur weist an sich bereits die vorteilhafte Reduktion der starken Spannungsabhängigkeit des Sperrstromes auf und bewirkt bereits eine verbesserte Sperrfähigkeit des MPS-Bauelements. Gleichzeitig ist die technologische Umsetzung der Struktur sehr einfach. Insbesondere lassen sich bei Standard-Dioden eine Abschirmanordnung 8 in Form eines Gitters oder anderer geeigneter Geometrien, insbesondere Streifen und Punkte, in einem Technologieschritt zusammen mit dem Schutzring 7 und gegebenenfalls auch mit mehreren sogen. Feldringen herstellen. Es entsteht kein zusätzlicher technologischer Aufwand.

Ein Nachteil der bekannten Struktur liegt darin, daß aktive Schottky-Fläche verloren geht. Ein sehr großer Nachteil besteht darin, daß bei Vorwärtsbetrieb des Bauelements Minoritätsladungsträger aus den Abschirmgebieten 7 in die Driftzone des Halbleitergebiets 2 zu injizieren. Bei einer Vorwärtspolung des MPS-Bauelements fließt der Strom zunächst nur über die Schottky-Bereiche. Bei weiter ansteigender Vorwärtsspannung geraten dann auch die pn-Übergänge 9 in Durchlaß, wobei Minoritätsladungsträger in das Driftgebiet 2 und 10 injiziert werden. Aufgrund des relativ großen Flächenanteils der Abschirmanordnung 8, insbesondere der p⁺-Gebiete, ist diese Injektion anders als bei den Schottky-Dioden mit Schutzring 7 nicht mehr vernachlässigbar.

Dieser Vorgang kann sogar bis zur Bildung eines Elektron-Loch-Plasmas im Driftgebiet des Halbleitergebiets 2 führen, was zwar die Durchlaßeigenschaften leicht verbessert, jedoch erhebliche Schaltverluste des Bauelements verursacht.

Erfindungsgemaß wird bei der Auswahl des Halbleitermaterials und des Schottky-Materials eine Materialkombination gewählt, bei der sichergestellt ist, daß die Differenz aus Größe der energetischen Bandlücke im elektronischen Anregungsspektrum des Halbleiters und der energetischen Höhe der Schottky-Barriere im spannungslosen Zustand des Bauelements größer oder gleich einem vorgegebenen Energiewert, bevorzugt mindestens 0,8 eV, besonders bevorzugt mindestens 1 eV beträgt. Vereinfacht kann man annehmen, daß bei einem pn-Übergang eine um den Differenzwert ΔU höhere Spannung als bei einem Schottky-Kontakt notwendig ist, um denselben Strom l₀ fließen zu lassen. Der Differenzwert ΔU bei einem erfindungsgemäßen MPS-Bauelement kann vereinfacht als die Spannungsdifferenz zwischen dem bei einer ersten Spannung einsetzenden Gesamtstrom l₀ und dem bei einer zweiten, höheren Spannung einsetzenden Injektionsstrom in derselben Höhe wie l₀ interpretiert werden.

Der Zusammenhang zwischen den Energiewerten und der Spannungsdifferenz ΔU ergibt sich zu ΔU = (E_{gap} - φ_{barrier})/q₀ + k, wobei E_{gap} die Energielücke des Halbleiters, φ_{barrier} die Höhe der Schottky-Barriere, q₀ die Elementarladungskonstante und k eine Konstante darstellt, die durch die effektive Richardson-Konstante, die Temperatur, den Ladungsträgerzustandsdichten, den Ladungsträgerbeweglichkeiten, den Ladungsträgerlebensdauern, den Dotierungen und dem Flächenverhältnis von Schottky-Übergang zu pn-Übergangsfläche abhängt. Für übliche Werte der Parameter bei vergleichbaren Bauelementen ist k im Bereich von einigen 10 mV bis zu wenigen 100 mV und damit im wesentlichen vernachlässigbar. Die Schottky-Barriere φ_{barrier} wird bevorzugt aus der Vorwärtskennlinie der Diode in an sich bekannter Weise bestimmt.

Die Absolutwerte von Bandlücke E_{gap} und Schottky-Barriere φ_{barrier} sind für die Spannungsdifferenz ΔU nicht sehr erheblich. Da die Schaltverluste um so geringer sind, je größer die Spannungsdifferenz ΔU ist, ist es zweckmäßig, geeignete Halbleiter-Schottky-Material-Kombinationen auszuwählen.

Bevorzugt sind als Halbleitermaterial solche mit großer Bandlücke E_{gap} geeignet, besonders bevorzugt die verschiedenen Polytypen des Siliziumkarbids, Galliumnitrid, Aluminiumnitrid und Diamant. Bei der Wahl des optimalen Schottky-Kontaktmaterials ist darauf zu achten, daß einerseits die Schottky-Barriere φ_{barrier} klein genug ist, um einen möglichst großen Energieunterschied zwischen Bandlücke E_{gap} und Schottky-Barrierenhöhe φ_{barrier} zu erzielen, andererseits die Schottky-Barriere groß genug ist, um günstige Sperreigenschaften zu erzielen. Besonders günstig ist es, die Schottky-Barrierenhöhe φ_{barrier} größer als 0,5 eV, besonders bevorzugt größer als 0,8 eV zu wählen. Zweckmäßig ist eine Schottky-Barrierenhöhe φ_{barrier} geringer als 2 eV. Das erfindungsgemäße Bauelement ist damit besonder gut für den Einsatz im Bereich hoher Sperrspannungen geeignet, bevorzugt für den Bereich größer 200 V, besonders bevorzugt größer 600 V.

Vorteilhaft sind insbesondere Kombinationen von Siliziumkarbid als Halbleiter mit Metallen, insbesondere Titan, Aluminium, Palladium, Gold, Silber, Nickel oder mit Kombinationen von Metallen, insbesondere Titan/Aluminium, Titan/Nickel/Silber und dergl. oder mit Siliziden, insbesondere TiSi₂ oder andere geeignete Metall/Halbleiterkombinationen, welche die Bedingung, daß die Differenz zwischen Bandlücke E_{gap} und Schottky-Barrierenhöhe φ_{barrier} größer oder gleich 0,8 eV, besonders bevorzugt 1 eV sein muß, erfüllen.

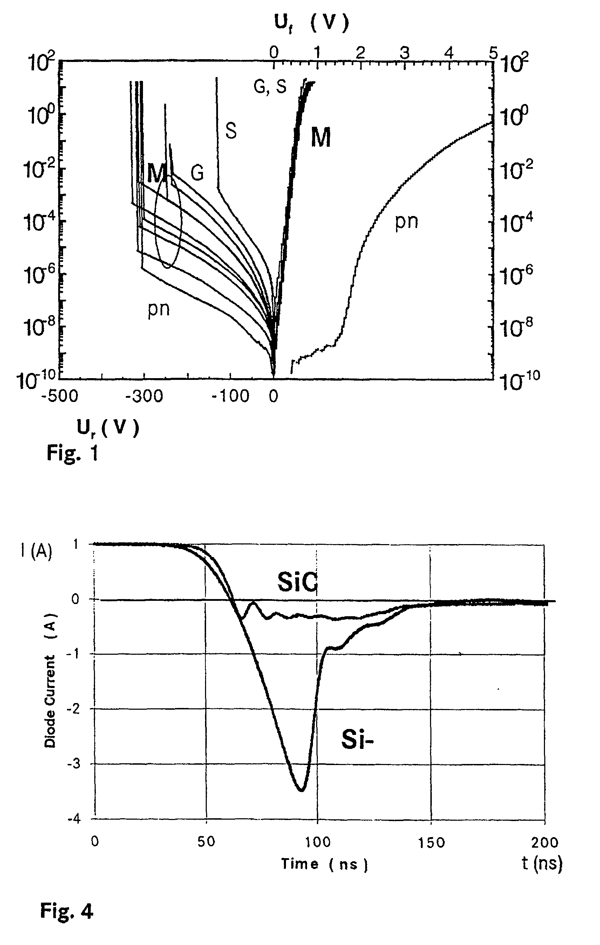

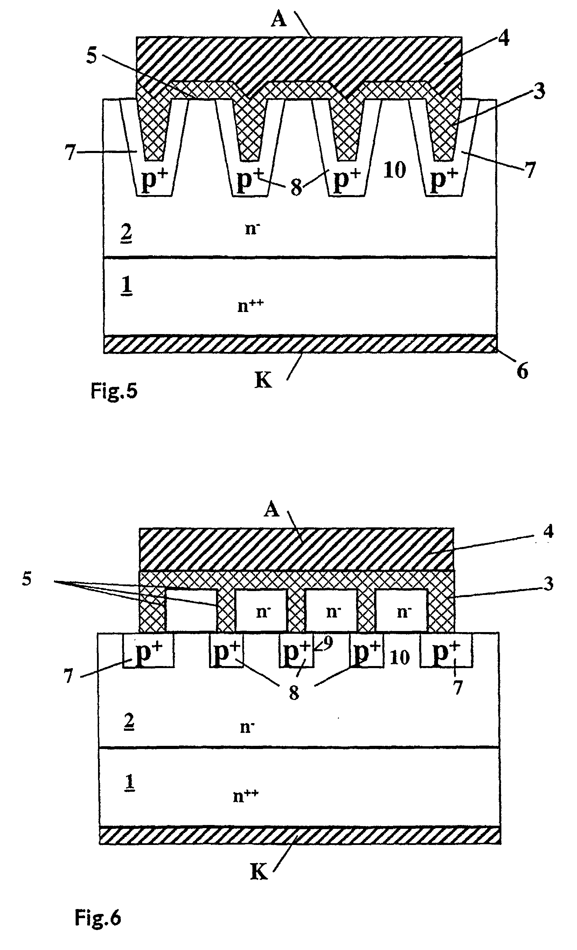

Wird ein MPS-Bauelement in Vorwärtsrichtung betrieben, so injizieren die pn-Übergänge 9 erst bei deutlich höheren Flußspannungen Minoritätsladungsträger in das Driftgebiet des Halbleiters. Dies ist in Fig. 1 dargestellt. Im Normalbetrieb der Diode tritt dann nur noch eine vernachlässigbare Injektion auf, so daß keine zusätzlichen Schaltverluste durch das sogen. 'Ausräumen' von Minoritätsladungsträgern aus dem Driftgebiet oder durch eine etwaige Rückstromspitze entstehen. Dies ist in Fig. 4 dargestellt.

In Fig. 1 sind gemessene Kennlinien von erfindungsgemäßen Siliziumkarbid-MPS-Bauelementen mit verschiedenen Abschirmgeometrien M mit Kennlinien anderer Bauelemente, insbesondere Schottky-Dioden S, Schottky-Dioden mit Schutzring G sowie pn-Dioden PN, sowohl in Vorwärts- als auch in Sperrichtung miteinander verglichen. Die vorteilhafte Wirkung der erfindungsgemäßen Anordnung ist deutlich zu erkennen. Bei den erfindungsgemäßen MPS-Bauelementen M fließt in Vorwärtsrichtung bereits bei sehr geringen Spannungen ein hoher Strom, ähnlich wie bei den in Vorwärtsrichtung günstigen Bauelementen S und G, während bei der pn-Diode PN für vergleichbare Ströme deutlich höhere Spannungen angelegt werden müssen. In Sperrichtung ist der Leckstrom der erfindungsgemäßen MPS-Bauelemente M deutlich geringer als bei Schottky-Dioden S und G mit und ohne Schutzring und zeigt ähnlich günstige Sperreigenschaften wie die pn-Diode PN.

In Fig. 4 sind Kennlinien eines Bauelements aus SiC und eines vergleichbaren Bauelements aus Si dargestellt, welche das Abschaltverhalten der Bauelemente charakterisieren. Die Bauelemente werden von 1A Vorwärtsstrom gegen 500 V Sperrspannung abgeschaltet. Das Si-Bauelement ist eine pn-Diode und zeigt das charakteristisch schlechte Abschaltverhalten. Die Kennlinie des Si-Bauelements fällt steil ab und zeigt einen starken Unterschwinger (reverse recovery) zu hohen negativen Strömen, die wesentlich höher sind als der eigentliche Vorwärtsstrom von 1 A, was darauf zurückzuführen ist, daß aus Driftgebiet des Halbleiters zahlreiche Minoritätsladungsträger entfernt werden müssen. Dies führt zu einem sehr nachteiligen Schaltverhalten mit großen Schalt-Verlusten dieses Si-Bauelements.

Dagegen sind im Driftgebiet des erfindungsgemäßen Bauelements nur sehr wenige Minoritätsladungsträger vorhanden, da deren Injektion durch die erfidnungsgemäße Spannungsdifferenz ΔU weitgehend unterbunden ist. Der Strom im Reverse-Recovery-Bereich ist deshalb nur ein Bruchteil des eigentlichen Vorwärtsstromes. Das Abschaltverhalten des erfindungsgemäßen Bauelements ist genauso schnell wie z.B. bei reinen Schottky-Dioden, die für schnelles Schaltverhalten bekannt sind, dagegen sind die Sperrverluste deutlich verbessert. Gegenüber pn-Dioden sind die Schaltverluste erheblich verringert. Das erfindungsgemäße Bauelement weist also einerseits die günstigen Eigenschaften der bekannten Schottky-Dioden wie verringerte Schaltverluste und einfache Technologie, weist aber deutlich geringere Sperrleckströme auf.

Der Vorteil der geringen Schauverluste bei erhöhter Sperrfestigkeit ist jedoch auch für solche erfindungsgemäßen Bauelemente erfüllt, bei denen das Sperrstromverhalten wegen der besonders großen Energielücke des Halbleiters nicht weiter verbessert ist, solange der Differenzwert zwischen Energielücke und Schottky-Barrierenhöhe mindestens 0,8 eV, bevorzugt mindestens 1 eV beträgt.

Die in den Figuren beschriebenen bevorzugten Ausführungsformen von erfindungsgemäßen MPS-Bauelementen stellen zwar vertikale Bauelemente dar, bei denen die äußeren Anschlüsse der Kathode K und Anode A auf gegenüberliegenden Oberflächen des Halbleiters angeordnet sind. Ein erfindungsgemäßes Bauelement kann jedoch ebenso als laterales Bauelement ausgeführt sein, bei denen die äußeren Kontakte Anode A und Kathode K auf derselben Oberfläche des Halbleiters angeordnet sind, insbesondere kann der eine äußere Kontakt den anderen umschließen, z.B. die Kathode die Anode ringförmig umgeben. In einem bevorzugten Ausführungsbeispiel kontaktiert ein äußerer Kontakt, insbesondere die Kathode K, das Driftgebiet des Halbleiters nur punktuell.

In einer weiteren bevorzugten Ausführungsform ist der Kathode ein hochdotiertes Halbleitergebiet vorgelagert, welches denselben Leitfähigkeitstyp aufweist wie das Driftgebiet des Halbleiters 2. Dies führt vorteilhaft dazu, daß der Kontakt zwischen Halbleiter und Kathoden-Kontakt verbessert ist und eine etwaige Ausdehnung der Raumladungszone zum Kathoden-Metall 6 unterbunden wird (sogen. 'punch through').

Die Erfindung gilt ebenso für komplementär dotierte MPS-Bauelemente.

In einer bevorzugten Ausführung wird hochdotiertes, insbesondere mit mehr als 10¹⁸ cm⁻³, n-leitendes oder p-leitendes Siliziumkarbid, vorzugsweise n-leitendes 4H-Siliziumkarbid, als Substrat 1 verwendet. Die Anordnung ähnelt der in Fig. 3 beschriebenen Anordnung. Auf das Substrat 1 wird ein Driftgebiet 2 gleichen Ladungstyps wie das Substrat angeordnet, vorzugsweise homoepitaktisch abgeschieden. Die Dicke des Driftgebiets liegt vorzugsweise zwischen 2 µm und 50 µm. Die Dotierung liegt vorzugsweise zwischen etwa 10¹⁴ und 10¹⁷ cm⁻³.

In das Driftgebiet 2 werden im wesentlichen in oberflächennahen Bereichen Dotierstoffatome strukturiert eingebracht. Driftgebiet 10 und Dotiergebiete 7, 8 wechseln sich ab. Für ein p-Typ-Driftgebiet ist vorzugsweise Aluminium oder Bor, für ein n-Typ-Driftgebiet ist vorzugsweise Stickstoff oder Phosphor zu wählen. Die entstehenden Gebiete 7 und 8 sind vom dem Ladungsträgertyp der Driftzone 10 entgegengesetzten Ladungsträgertyp und bilden pn-Übergänge 9.

Das Einbringen der strukturierten Dotierstoffe in die Oberfläche des Driftgebiets 2 kann mittels Diffusion oder vorzugsweise mittels lonenimplantationstechniken erfolgen. Der Abstand der Dotiergebiete 7 und B kann so optimiert werden, daß sich etwaige Ruheraumladungszonen benachbarter pn-Übergänge 9 nicht berühren. Dadurch wird erreicht, daß der Ladungsträgerdurchlaß in Vorwärtsrichtung nicht behindert wird. Andererseits müssen die pn-Übergänge 9 so dicht beieinander liegen, daß bei anliegender Sperrspannung am Bauelement der Bereich zwischen benachbarten pn-Übergängen 9 durch sich mit steigender Sperrspannung ausbreitender Raumladungszonen im Gebiet 10 sicher abgeschnürt wird.

Der optimale Abstand zwischen den pn-Übergängen 9 hängt neben der Dotierung und dem Halbleitermaterial auch von der Geometrie der pn-Abschirmung 8 ab, welche insbesondere eins Streifen-, Gitter-, Ring-, Spiral-, Hexagonal- oder Punktestruktur aufweisen kann.

Vorzugsweise liegt der Abstand zwischen benachbarten pn-Übergängen zwischen 0,5 µm und 20 µm.

Auf das Einbringen der Abschirmung erfolgt eine Temperaturbehandlung, insbesondere zwischen 1400°C und 1700°C, die etwaige Implantationsschäden ausheilt, den Dotierstoff tiefer eintreibt und thermisch aktiviert. Besonders bevorzugt ist, eine mehrstufige Temperaturbehandlung durchzuführen, wie sie in den Anmeldungen DE 196 33 183 und DE 196 33 184 für die Temperaturbehandlung von Halbleiterbauelementen mit flüchtigen, insbesondere sublimierenden Komponenten, insbesondere Siliziumkarbid, offenbart ist. Das Verfahren besteht darin, daß die Temperaturbehandlung so ausgeführt wird, daß das Bauelement für einen begrenzten Zeitraum erst bei einer Temperatur zwischen 500°C und 1500°C und anschließend bei einer Temperatur von mehr als 1500°C gehalten wird. Besonders vorteilhaft ist, während der Temperaturbehandlung in unmittelbarer Nachbarschaft des Bauelements Silizium, insbesondere in einem etwaigen Ausheiltiegel, in dem das Bauelement während der Temperaturbehandlung lagert, beizugeben. Der ganz besondere Vorteil dabei ist, daß die Oberfläche des MPS-Bauelements trotz der hohen Temperatur im eigentlichen Ausheilschritt durch einen vorangehenden Konditionierungsschritt glatt bleibt. Anschließend wird die Metallisierung für Vorderseite (Schottky-Metall) und Rückseite (Ohmscher Kontakt) abgeschieden, strukturiert und bei Bedarf thermisch behandelt.

In Fig. 5 ist ein erfindungsgemäßes Bauelement dargestellt, bei dem vor dem Einbringen der Dotierung für die Abschirmung an den Stellen, an denen die Abschirmung eingebracht werden soll, Ätzgruben in die Driftzone 2 eingeätzt sind. Dies hat den Vorteil, daß die pn-Übergänge weit in das Driftgebiet 2 hineinreichen, wodurch sich die Abschnürung der Schottkybereiche verbessert.

In einer weiteren bevorzugten Anordnung, welche in Fig. 6 dargestellt ist, ist nach dem Einbringen der Abschirmzonen 8 eine Epitaxieschicht aufgebracht, die denselben Leitfähigkeitstyp wie das Driftgebiet 2 aufweist. Dies hat zur Folge, daß die Abschirmzonen 8 vergraben sind. Die Abschirmzonen werden anschließend wieder freigelegt, insbesondere freigeätzt, und erst dann metallisiert. Auf diese Weise wird vorteilhaft die aktive Schottky-Fläche um die Seitenflächen der Ätzung vergrößert, was den Flächenverlust durch die Abschirmzonen 8 mindestens kompensiert, insbesondere überkompensiert.

## Patentansprüche

1. Verfahren zur Herstellung eines MPS-Halbleiterbauelements mit einer Anode und einer Kathode bei dem auf einer Halbleiterschicht (2) mehrere Schottky-Kontakte angebracht sind, deren Randbereiche jeweils mit einer Abschirmung aus einem zur Halbleiterschicht komplementär hochdotierten Halbleitergebiet (7,8) versehen sind, so daß die Abschirmung an den Randbereichen der Schottky-Übergänge (5) mit der Halbleiterschicht (2) jeweils einen pn-Übergang (9) bildet und die Halbleiterschicht (2) unter den einzelnen Schottky-Kontakten und zwischen den einzelnen pn-Übergängen (9) jeweils eine Driftzone (10) bildet, wobei
die Energiedifferenz (E_{gap} - φ_{barrier}) zwischen der Bandlücke (E_{gap}) im elektronischen Anregungsspektrum des Driftzonen-Halbleiters (10) und der energetischen Höhe (φ_{barrier}) der Schottky-Barriere (5) im spannungslosen Zustand des Halbleiterbauelements mindestens 0,8 eV ist,
**dadurch gekennzeichnet,**
**daß** auf ein mit einem ersten Dotierstoff von mindestens 10¹⁸ cm⁻³ dotiertes Siliziumkarbidsubstrat (1) eine mit einem zweiten Dotierstoff desselben Ladungsträgertyps im Bereich von zwischen 10¹⁴ und 10¹⁷ cm⁻³ dotierte Halbleiterschicht (2) homoepitaktisch abgeschieden wird, worauf in die vom Substrat entfernt angeordnete Oberfläche der Halbleiterschicht ein dritter Dotierstoff des komplementären Ladungsträgertyps strukturiert mittels Diffusion und/oder Innenimplantation zur Bildung der die Abschirmung bildenden pn-Übergänge (7,8,9) eingebracht wird, anschließend das Bauelement einer Temperaturbehandlung zwischen 1400°C und 1700°C unterzogen wird, nach der Temperaturbehandlung eine erste metallische Schicht auf der implantierten Oberfläche zur Bildung eines Schottky-Kontaktes und eine zweite metallischen Schicht zur Bildung eines ohmschen Kontaktes aufgebracht und die erste und zweite Schicht anschließend strukturiert wird.

2. Verfahren nach Anspruch 1, **dadurch gekennzeichnet,**
**daß** während der Temperaturbehandlung das Bauelement für einen begrenzten Zeitraum bei einer Temperatur zwischen 1400°C und 1500°C gehalten wird
und anschließend das Bauelement bei einer zweiten Temperatur von mehr als 1500°C weiterbehandelt wird.

3. Verfahren nach Anspruch 1 oder 2, **dadurch gekennzeichnet,**
**daß** während der Temperaturbehandlung das Bauelement in unmittelbarer Nachbarschaft von elementarem Silizium erhitzt wird

4. Verfahren nach mindestens einem der vorangegangenen Ansprüche,
**dadurch gekennzeichnet,**
**daß** die Energiedifferenz (E_{gap} - φ_{barrier}) mindestens 1 eV ist.

5. Verfahren nach mindestens einem der vorangegangenen Ansprüche,
**dadurch gekennzeichnet,**
**daß** die energetische Höhe der Schottky-Barriere (φ_{barrier}) größer als 0,5 eV und kleiner als 2 eV ist.

6. Verfahren nach mindestens einem der vorangegangenen Ansprüche,
**dadurch gekennzeichnet,**
**daß** die Halbleiterschicht (2) eine Dicke zwischen 2 µm und 50 µm aufweist.

7. Verfahren nach mindestens einem der vorangegangenen Ansprüche,
**dadurch gekennzeichnet,**
**daß** der Abstand benachbarter pn-Übergänge (9) zwischen 0,5 µm und 20 µm liegt.

8. Verfahren nach mindestens einem der vorangegangenen Ansprüche,
**dadurch gekennzeichnet,**
**daß** die pn-Übergänge (9) in in die Halbleiterschicht (2) hineingeätzte Gräben angeordnet sind.

9. Verfahren nach mindestens einem der vorangegangenen Ansprüche,
**dadurch gekennzeichnet,**
**daß** die hochdotierten Hableitergebiete der Abschirmung (7, 8) einerseits und die Driftzonen(10) andererseits durch unterschiedliches Halbleitermaterial gebildet sind.

10. Verfahren nach mindestens einem der vorangegangenen Ansprüche,
**dadurch gekennzeichnet,**
**daß** die Kathode (K) und die Anode (A) auf gegenüberliegenden Oberflächen des Halbleiterbauelements angeordnet sind.

11. Verfahren nach mindestens einem der vorangegangenen Ansprüche,
**dadurch gekennzeichnet,**
**daß** die Kathode (K) und die Anode (A) auf derselben Oberfläche des Halbleiterbauelements angeordnet sind.

12. Verfahren nach mindestens einem der vorangegangenen Ansprüche,
**dadurch gekennzeichnet,**
**daß** der Kathode ein hochdotiertes Halbleitergebiet (1) vorgelagert ist, welches denselben Leitfähigkeitstyp aufweist wie die Halbleiterschicht (2).

## Claims

1. Method for producing an MPS semiconductor component with an anode and a cathode in which there are mounted on a semiconductor layer (2) several Schottky contacts, the edge regions of which are each provided with a shielding consisting of a high-doped semiconductor region (7, 8) complementary to the semiconductor layer, so that the shielding forms a respective pn transition (9) at each of the edge regions of the Schottky transitions (5) with the semiconductor layer (2) and the semiconductor layer (2) forms a respective drift zone (10) under the individual Schottky contacts and between the individual pn transitions (9), wherein the energy difference (E_{gap} - φ_{barrier}) between the band gap (E_{gap}) in the electronic excitation spectrum of the drift zone semiconductor (10) and the energetic level (φ_{barrier}) of the Schottky barrier (5) in the voltage-free state of the semiconductor component is at least 0.8 eV, **characterised in that** there is homoepitaxially precipitated on a silicon carbide substrate (1), which is doped with a first doping material of at least 10¹⁸ cm⁻³, a semiconductor layer (2) doped with a second doping material of the same charge carrier type in the range of between 10¹⁴ and 10¹⁷ cm⁻³, whereupon a third doping material of the complementary charge carrier type structured by means of diffusion and/or ion implantation for formation of the pn transitions (7, 8, 9) forming the shielding is introduced into the surface of the semiconductor layer remote from the substrate, subsequently the component is subjected to a temperature treatment between 1400° C and 1700° C, after the temperature treatment a first metallic layer is deposited on the implanted surface for formation of a Schottky contact, a second metallic coating is deposited for formation of a resistive contact and the first and second layer are subsequently structured.

2. Method according to claim 1, **characterised in that** during the temperature treatment the component is kept for a limited period of time at a temperature between 1400° C and 1500° C and subsequently the component is further treated at a second temperature of more than 1500° C.

3. Method according to claim 1 or 2, **characterised in that** during the temperature treatment the component is heated in the immediate vicinity of elemental silicon.

4. Method according to at least one of the preceding claims, **characterised in that** the energy difference (E_{gap} - φ_{barrier}) is at least 1 eV.

5. Method according to at least one of the preceding claims, **characterised in that** the energetic level of the Schottky barrier (φ_{barrier}) is greater than 0.5 eV and less than 2 eV.

6. Method according to at least one of the preceding claims, **characterised in that** the semiconductor layer (2) has a thickness between 2 microns and 50 microns.

7. Method according to at least one of the preceding claims, **characterised in that** the spacing of adjacent pn transitions (9) lies between 0.5 microns and 20 microns.

8. Method according to at least one of the preceding claims, **characterised in that** the pn transitions (9) are arranged in trenches etched into the semiconductor layer (2).

9. Method according to at least one of the preceding claims, **characterised in that** the high-doped semiconductor regions of the shielding (7, 8) on the one hand and the drift zones (10) on the other hand are formed by different semiconductor material.

10. Method according to at least one of the preceding claims, **characterised in that** the cathode (K) and the anode (A) are arranged on opposite surfaces of the semiconductor component.

11. Method according to at least one of the preceding claims, **characterised in that** the cathode (K) and the anode (A) are arranged on the same surface of the semiconductor component.

12. Method according to at least one of the preceding claims, **characterised in that** a high-doped semiconductor region (1) is disposed in front of the cathode and has the same conductivity type as the semiconductor layer (2).

## Revendications

1. Procédé de fabrication d'un composant à semi-conducteur MPS avec une anode et une cathode, où sont disposés sur une couche semi-conductrice (2) plusieurs contacts de Schottky dont les zones de bord sont pourvues chacune d'un écran constitué d'une zone semi-conductrice hautement dotée (7, 8) complémentaire à la couche semi-conductrice de telle sorte que l'écran forme aux zones de bord des barrières de Schottky (5) avec la couche semi-conductrice (2) respectivement une jonction pn (9) et que la couche semi-conductrice (2) forme entre les contacts de Schottky individuels et entre les jonctions pn individuelles (9) respectivement une zone de déplacement (10) où
la différence d'énergie (E_{gap}-φ_{barrier}) entre l'écart énergétique (E_{gap}) dans le spectre d'excitation électronique du semi-conducteur de zone de déplacement (10) et la hauteur énergétique (φ_{barrier}) de la barrière de Schottky (5) à l'état sans tension du composant à semi-conducteur est au moins de 0,8 eV, **caractérisé en ce qu'**on dépose sur un substrat de carbure de silicium (1) doté d'un premier agent de dopage d'au moins 10¹⁸ cm⁻³ d'une manière homo-épitactique une couche semi-conductrice (2) dotée d'un deuxième agent de dopage du même type de support de charge dans la plage entre 10¹⁴ et 10¹⁷ cm⁻³, à la suite de quoi est introduit dans la surface de la couche semi-conductrice disposée à distance du substrat un troisième agent de dopage d'un type de support de charge complémentaire structuré par diffusion et/ou implantation d'ions pour former les jonctions pn (7, 8, 9) formant l'écran, ensuite le composant est soumis à un traitement thermique entre 1400°C et 1700°C, après le traitement thermique, une première couche métallique est appliquée sur la surface implantée pour former un contact de Schottky et une deuxième couche métallique pour former un contact ohmique, et la première et la deuxième couche sont ensuite structurées.

2. Procédé selon la revendication 1, **caractérisé en ce que** pendant le traitement thermique, le composant est maintenu pendant une durée de temps limitée à une température entre 1400°C et 1500°C, et qu'ensuite le traitement de composant est poursuivi à une seconde température supérieure à 1500°C.

3. Procédé selon la revendication 1 ou 2, **caractérisé en ce que** pendant le traitement thermique, le composant est chauffé au voisinage direct de silicium élémentaire.

4. Procédé selon au moins l'une des revendications précédentes, **caractérisé en ce que** la différence énergétique (E_{gap}-φ_{barrier}) est au moins de 1 eV.

5. Procédé selon au moins l'une des revendications précédentes, **caractérisé en ce que** la hauteur énergétique de la barrière de Schottky (φ_{barrier}) est plus grande que 0,5 eV et plus petite que 2 eV.

6. Procédé selon au moins l'une des revendications précédentes, **caractérisé en ce que** la couche semi-conductrice (2) présente une épaisseur entre 2 µm et 50 µm.

7. Procédé selon au moins l'une des revendications précédentes, **caractérisé en ce que** l'écart de jonctions pn avoisinantes (9) est compris entre 0,5 µm et 20 µm.

8. Procédé selon au moins l'une des revendications précédentes, **caractérisé en ce que** les jonctions pn (9) sont disposées dans des évidements réalisés par attaque chimique dans la couche semi-conductrice (2).

9. Procédé selon au moins l'une des revendications précédentes, **caractérisé en ce que** les zones semiconductrices hautement dotées de l'écran (7, 8) d'une part, et les zones de déplacement (10), d'autre part, sont formées par des matériaux semi-conducteurs différents.

10. Procédé selon au moins l'une des revendications précédentes, **caractérisé en ce que** la cathode (K) et l'anode (A) sont disposées sur des surfaces opposées du composant à semi-conducteur.

11. Procédé selon au moins l'une des revendications précédentes, **caractérisé en ce que** la cathode (K) et l'anode (A) sont disposées sur la même surface du composant à semi-conducteur.

12. Procédé selon au moins l'une des revendications précédentes, **caractérisé en ce qu'**il est disposé en amont de la cathode une zone semi-conductrice hautement dotée (1) qui présente le même type de conductivité que la couche semi-conductrice (2).
